Europäisches Patentamt

European Patent Office

Office européen des brevets

(11) Veröffentlichungsnummer: **0 427 011 A2**

# (12) EUROPÄISCHE PATENTANMELDUNG

(21) Anmeldenummer: **90119784.8**

(22) Anmeldetag: **16.10.90**

(51) Int. Cl.5: **H03M 1/00**

(30) Priorität: **08.11.89 DE 3937140**

(43) Veröffentlichungstag der Anmeldung:
**15.05.91 Patentblatt 91/20**

(84) Benannte Vertragsstaaten:
**AT CH DE ES FR GB IT LI SE**

(71) Anmelder: **Blaupunkt-Werke GmbH**
**Robert-Bosch-Strasse 200**
**W-3200 Hildesheim(DE)**

(72) Erfinder: **Cording, Karl-Heinz**
**Hostmannstrasse 4**
**W-3200 Hildesheim(DE)**

(74) Vertreter: **Eilers, Norbert, Dipl.-Phys.**
**Blaupunkt-Werke GmbH**
**Robert-Bosch-Strasse 200**
**W-3200 Hildesheim(DE)**

(54) **Schaltungsanordnung zur Abfrage des Bedienungszustandes von Funktionstasten.**

(57) Es wird eine neue Schaltungsanordnung zur Abfrage des Bedienungszustandes von Tasten durch einen Mikroprozessor beschrieben, die eine geringere Anzahl von Mikroprozessoranschlüssen benötigt.

Fig. 1

## SCHALTUNGSANORDNUNG ZUR ABFRAGE DES BEDIENUNGSZUSTANDES VON FUNKTIONSTASTEN

Gegenstand des Schutzrechtes ist eine neue Schaltung zur Abfrage des Bedienungszustandes von Funktionstasten durch einen Mikroprozessor.

Es ist üblich, die Funktionstasten zur Abfrage des Bedienungszustandes in den Kreuzungspunkten einer Abfrage-Leitungsmatrix anzuordnen und bei der Bedienung einer Funktionstaste eine Verbindung zwischen den sich in diesem Punkt kreuzenden Zeilen- und Spaltenleitungen herzustellen, so daß ein in der Zeilenleitung fließender Strom im Kreuzungspunkt in die Spaltenleitung übertritt und dort einen Rückstrom hervorruft.

Die Zeilenleitungen sind dazu mit zum Senden geeigneten und die Spaltenleitungen mit zum Empfangen geeigneten Anschlüssen eines Mikroprozessors verbunden.

Zur Abfrage werden vom Mikroprozessor nacheinander in jeder Reihenleitung kurzzeitig Stromflüsse erzeugt und während dieser kurzen Stromflußzeit werden alle Spaltenleitungen vom Mikroprozessor nacheinander auf einen Rückstromfluß hin geprüft. Diese Abfrage ist als Routine-Subprogramm in das Mikroprozessorprogramm eingefügt, d. h. das Steuerprogramm des Mikroprozessors sorgt für die zeitgerechte Einschaltung der Zeilenleitungen und Abfrage der Spaltenleitungen. Des weiteren verarbeitet der Mikroprozessor das Ergebnis der Abfrage in dem durch sein Programm vorgeschriebenen Ablauf weiter.

Die Abfrage des Bedienungszustandes von Funktionstasten hat den Nachteil eines erheblichen Bedarfs an Anschlüssen an einen Mikroprozessor, deren Anzahl begrenzt ist. Es besteht daher die Aufgabe, die für die Abfrage von Funktionstasten erforderliche Anzahl von zu belegenden Anschlüssen an einem Mikroprozessor zu verringern.

Die Erfindung, die durch die Merkmale des Anspruchs 1 gekennzeichnet ist, löst diese Aufgabe.

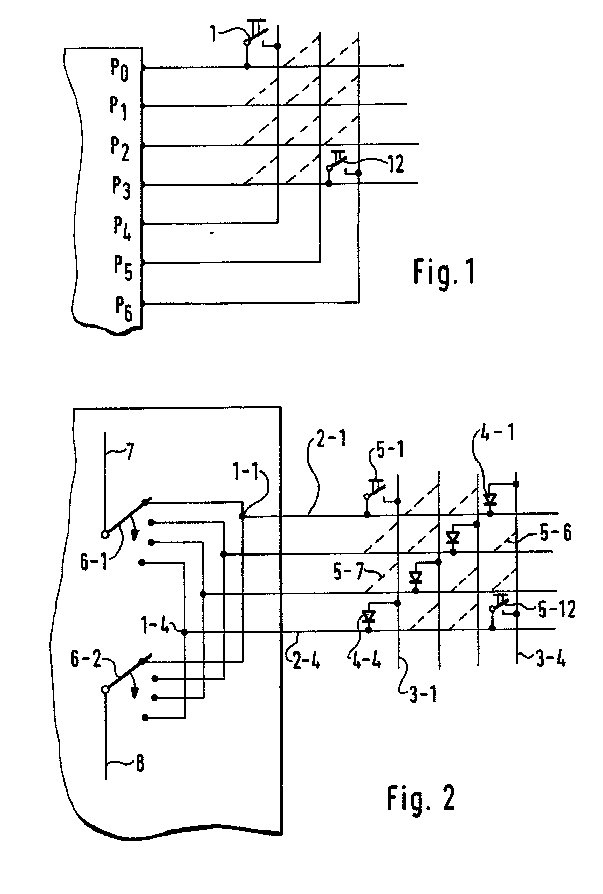

Anhand der Zeichnung wird die Erfindung näher erläutert. Darin zeigt Figur 1 ein Tastenfeld mit 12 Tasten nach dem Stand der Technik, wie es in der Einleitung schon beschrieben ist, und Figur 2 eine erfindungsgemäße Schaltung mit 12 Tasten.

Die erfindungsgemäße Schaltung erfordert bei 12 Tasten statt sieben nur vier Anschlüsse Mikroprozessor für die Abfrage des Bedienungszustandes, wie ein Vergleich der Figuren 1 und 2 zeigt.

Allgemein gilt, daß mit n-Mikroprozessor-Anschlüssen
(n -1) n Schalter
abgefragt werden können und daß für die Abfrage von
(n -1) (n -2) + 1-Schaltern
mindestens n Anschlüsse am Mikroprozessor erforderlich sind.

Wie der Figur 2 zu entnehmen ist, sind den vier am Mikroprozessor 1 angeschlossenen Zeilenleitungen 2-1 bis 2-4 vier Spaltenleitungen 3-1 bis 3-4 zugeordnet und jede Spaltenleitung 3 ist an einem der Kreuzungspunkte mit den Zeilenleitungen 2 über eine Diode 4 ständig verbunden, d. h. die mit dem Anschluß 1-1 verbundene Zeilenleitung 2-1 ist an ihrem Kreuzungspunkt mit der Spaltenleitung 3-4 über die Diode 4-1 ständig an die Spaltenleitung 3-4 angeschlossen, während die mit dem Anschluß 1-4 verbundene Zeilenleitung 2-4 an ihrem Kreuzungspunkt mit der Spaltenleitung 3-1 über die Diode 4-4 an die Spaltenleitung 3-1 angeschlossen ist.

In den anderen Kreuzungspunkten verbinden die Funktionstasten 5 nur im Fall ihrer Bedienung die Zeilenleitungen 2 mit den Spaltenleitungen 3. Zugleich ist das Mikroprozessorprogramm dahingehend ausgelegt, daß über die einzelnen Zeilenleitungen 2 nacheinandet kurzzeitig Stromflüsse erzeugt werden, und daß die anderen Zeilenleitungen während dieser Stromflußzeit nacheinander auf einen Rückstromfluß hin geprüft werden.

Dies Steuerprogramm ist durch zwei Drehschalter 6-1 und 6-2 im Mikroprozessor symbolisiert, von denen der eine mit einer Sendeleitung 7 und der andere mit einer Empfangsleitung 8 im Mikroprozessor 1 verbunden ist. Die Steuerung der Drehschalter 6-1 und 6-2 ist voneinander abhängig und erfolgt in der Weise, daß in der Zeit während der der Drehschalter 6-1 mit der Zeilenleitung 2-1 verbunden ist, der Drehschalter 6-2 nacheinander mit den Zeilenleitungen 2-2 bis 2-4 verbunden wird usw.

Die Erfindung macht sich die Tatsache zunutze, daß in jedem Mikroprozessor durch den internen Aufbau Anschlüsse zur Verfügung stehen, die durch das Programm wahlweise als Sendeanschluß oder als Empfangsanschluß genutzt werden können, eine Fähigkeit, die beim Stand der Technik bisher nicht für diese Anwendung ausgenutzt wurde.

Wenn in dem Ausführungsbeispiel nach Figur 2 zur Abfrage des Bedienungszustandes der 12 Funktionstasten 5-1 bis 5-12 der Anschluß 1-1 des Mikroprozessors vom Programm als Sendeanschluß geschaltet ist, dann fließt kein Rückstrom in keinen der gleichzeitig aber nacheinander vom Mikroprozessor als Empfangsanschlüsse geschalteten Anschlüsse 1-2 bis 1-4. Ist jedoch die Funktionstaste 5-1 bedient, dann fließt ein Rückstrom in den Anschluß 1-4, weil die Funktionstaste 5-1 die oberste Zeilenleitung 2-1 mit der ersten Spaltenleitung 3-1 verbindet. Ist die Taste 3-12 bedient, dann fließt ein Rückstrom über die Diode 4-1 in den Anschluß 1-4, sobald das Pro gramm den Anschluß 1-1 des Mikroprozessors als Sendeanschluß schaltet.

Somit kann jede Funktionstaste nur über eine bestimmte Spaltenleitung einen Rückstrom in einen bestimmten Empfangsanschluß des Mikroprozessors verursachen, wenn ein bestimmter anderer Anschluß als Sendeanschluß arbeitet; d. h. die Zuordnung ist eindeutig.

Werden gleichzeitig mehrere Funktionstasten betätigt, z. B. die Funktionstasten 5-1 und 5-7, dann fließt ein Rückstrom sowohl über die Zeilenleitung 2-2 in den Anschluß 1-2 als auch über die Zeilenleitung 2-4 in den Anschluß 1-4, sobald diese Anschlüsse als Empfangsanschlüsse geschaltet sind.

## Ansprüche

1. Schaltungsanordnung zur Abfrage des Bedienungszustandes von Funktionstasten, in Kreuzungspunkten von in Zeilen- und Spalten angeordneten Abfrageleitungen, die im Fall der Bedienung in ihrem Kreuzungspunkt die zugeordnete Spaltenleitung mit der zugeordneten Zeilenleitung verbinden, durch einen Mikroprozessor,
dadurch gekennzeichnet,
daß n Zeilenleitungen mit n wahlweise zum Senden und Empfangen schaltbaren Anschlüssen des Mikroprozessors verbunden sind, daß in jeweils einem Kreuzungspunkt einer Zeilenleitung mit einer Spaltenleitung diese ständig über eine Diode miteinander verbunden sind, derart, daß jeweils eine Spaltenleitung an eine Zeilenleitung angeschlossen ist,
daß die Dioden in gleicher Stromflußrichtung gepolt sind, und daß die n Anschlüsse des Mikroprozessors nacheinander für eine vorgegebene Zeitdauer als Sendeanschluß und während dieser Zeitdauer die anderen Anschlüsse nacheinander als Empfangsanschlüsse geschaltet sind.

Fig. 1

Fig. 2